(19) Europäisches Patentamt / European Patent Office / Office européen des brevets

(11) EP 2 703 827 B1

(12) **EUROPEAN PATENT SPECIFICATION**

(45) Date of publication and mention of the grant of the patent:
**06.07.2016 Bulletin 2016/27**

(51) Int Cl.:
*G01R 31/00* (2006.01)     *H02J 3/00* (2006.01)
*H02H 6/00* (2006.01)      *G01R 21/00* (2006.01)
*G01R 25/00* (2006.01)     *G01R 27/26* (2006.01)
*H02H 7/26* (2006.01)      *G01R 19/25* (2006.01)

(21) Application number: **12868417.2**

(22) Date of filing: **27.09.2012**

(86) International application number:
**PCT/CN2012/082214**

(87) International publication number:
**WO 2013/120352 (22.08.2013 Gazette 2013/34)**

(54) **METHOD FOR ESTIMATING DYNAMIC POWER TRANSMISSION LINE CAPACITY BY USING SYNCHRONIZED PHASOR TECHNOLOGY**

VERFAHREN ZUR SCHÄTZUNG DER DYNAMISCHEN KAPAZITÄT EINER STROMÜBERTRAGUNGSLEITUNG MITHILFE EINER SYNCHRONISIERTEN PHASOR-TECHNOLOGIE

PROCÉDÉ D'ESTIMATION DE CAPACITÉ DYNAMIQUE DE LIGNE DE TRANSPORT D'ÉLECTRICITÉ PAR UTILISATION D'UNE TECHNOLOGIE DE PHASEURS SYNCHRONISÉS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.02.2012 CN 201210032464**

(43) Date of publication of application:
**05.03.2014 Bulletin 2014/10**

(73) Proprietor: **Guangdong East Power Co., Ltd.**
**DonggGuan, Guangdong 523000 (CN)**

(72) Inventors:
  • **MAI, Ruikun**
    **Dongguan, Guangdong 523000 (CN)**
  • **FU, Ling**
    **Dongguan, Guangdong 523000 (CN)**
  • **XU, Haibo**
    **Dongguan, Guangdong 523000 (CN)**
  • **HE, Simo**
    **Dongguan, Guangdong 523000 (CN)**

(74) Representative: **Office Kirkpatrick**
    **Avenue Wolfers, 32**
    **1310 La Hulpe (BE)**

(56) References cited:
EP-A1- 1 324 454          WO-A1-2006/068615
WO-A1-2008/017581         CN-A- 1 963 879
CN-A- 101 027 568         CN-A- 101 266 274
CN-A- 102 313 853         CN-A- 102 340 139
CN-A- 102 565 597         CN-U- 201 562 025
CN-Y- 2 879 209           JP-A- 2009 065 796
US-A1- 2008 189 061       US-A1- 2008 189 062
US-A1- 2010 114 392

• REN, LIJIA ET AL.: 'Research of Dynamic Line Rating System' AUTOMATION OF ELECTRIC POWER SYSTEMS vol. 30, no. 17, 10 September 2006, pages 45 - 49, XP008171645
• HAN FANG ET AL.: 'Application of Overhead Transmission Line Dynamic Ampacity Calculation Method' ELECTRIC POWER CONSTRUCTION vol. 29, no. 1, January 2008, pages 39 - 43, XP008171664
• QI, SHUQING ET AL.: 'Design and Realization of Data Sampling System for Dynamic Line Rating of Transmission Lines' EAST CHINA ELECTRIC POWER vol. 36, no. 2, February 2008, pages 89 - 92, XP008171650

**Description**

FIELD OF THE INVENTION

The invention relates to the field of electrical power systems and automation technologies thereof, in particular to a method for estimating a dynamic power transmission line capacity by using a synchronized phasor technology.

BACKGROUND OF THE INVENTION

New construction of power transmission lines is increasingly difficult due to the scarcity of land resources and high construction cost. The worst external environment is taken as a reference to consider power transmission capacity in a static method basically. Therefore, a larger margin is kept on estimation of transmission line capacity based on the static method so as to guarantee safety of power transmission lines. In the case of on-peak power utilization and relatively ideal weather, the transmission line capacity is not subject to a full utilization due to restriction of estimation of the transmission line capacity, consequently power grid is forced to switch into other power transmission corridors, thereby problems such as increasing line loss etc are possibly caused, or measures such as temporary interruption of power supply to a fraction of users are adopted, which is to the disadvantage of society development and users' demands on power grid.

Over the past ten years, relatively lots of researches are made by many scholars and researchers on estimation of the dynamic transmission line capacity, which is roughly classified into: 1. estimation of the dynamic transmission line capacity based on weather measurement, which is possibly the simplest and the most direct method as no equipment need installing on the power transmission line, heat increase per unit length of the power transmission line resulted by electric current is calculated on the basis of electric current actually flowing through the power transmission line, and heat loss of the power transmission line is obtained on the basis of current state of weather (such as wind, environment temperature and radiation etc.), in this way, net heat of the power transmission line can be calculated, thus obtaining an estimated temperature value of the power transmission line; 2. estimation of the dynamic transmission line capacity based on conductor sag and conductor tension, in this method, conductor temperature is estimated on the basis of the principle of a heated conductor being prolonged, a conductor rises in temperature and then prolongs when the transmission current becomes greater, thus increasing conductor sag, which causes tension increase of the conductor, the conductor temperature can be retrospectively calculated on the basis of the conductor sag and tension; 3. direct temperature measurement technique of the power transmission line, the most direct method, in which a temperature sensor is directly contacted with the conductor surface to measure the surface temperature of the conductor, with all factors influencing the transmission line capacity taken into account.

The first method has certain difficulty in accurate measurement of wind speed and other rapidly changing factors. In addition, it is problematic in terms of data exchange between weather stations and data centers as well as daily maintenance of weather stations due to a long transmission distance of the power transmission line; in the second method, a measuring equipment need installing on the power transmission line, the electromagnetic environment of the measuring equipment is relatively harsh, and it is extremely difficult for electromagnetic protection, communication and maintenance of the measuring equipment; in addition to the disadvantages in previously-mentioned two methods, in the third method, it is a great challenge for accurate measurement of temperature inside the conductor; furthermore, extra measuring equipment are required in the three methods and possibly need placing along the power transmission lines which possibly traverse relatively deserted zones in which communication is unavailable sometimes; high cost is required for maintenance of equipment in case of malfunction, dedicated lines are unlikely used in consideration of cost problem, thereby data communication reliability and rapidity are greatly reduced, and data transmission rate is difficult to be guaranteed.

With the continuous development of the wide-area measurement technology, a growing number of synchronized phasor measurement units are arranged in transmission grid so as to provide accurate voltage and current phasor information; accurate phasor estimation offered by the synchronized phasor technology provides a strong guarantee for estimation of dynamic transmission line capacity.

Document WO 2008/017581 A1 discloses a thermal model of a power line.

SUMMARY OF THE INVENTION

The invention, in allusion to the disadvantages of the above-mentioned background art, provides a method for estimating a dynamic power transmission line capacity by using a synchronized phasor technology, and a power transmission line model based on mechanical characteristics, thermodynamic characteristics and power characteristics, for determining the on-line power transmission capacity of the power transmission line and also solving the disadvantage that extra measuring equipment is added.

In order to achieve above-mentioned objectives, the invention discloses a method for estimating a dynamic power transmission line capacity by using a synchronized phasor technology comprising steps as below:

(1) Synchronized phasor measurement units are arranged at two sides of a power transmission line, one side of the power transmission line is a receiving end and the opposite side of the power transmission line is a sending end; the synchronized phasor measurement units measure voltage and current phasors of the power transmission line and transmit the voltage and current phasors to a data buffer of a measurement system;
(2) The power transmission line voltage and current phasors data in the data buffer of the measurement system is used for calculation of the total impedance of the power transmission line $Z(T_C) = Z_C(T_C) \cdot \gamma(T_C) \cdot l(TC)$,

in which, $Z_C(T_C) = \sqrt{\dfrac{U_S^2 - U_R^2}{I_S^2 - I_R^2}}$, $\quad \gamma(T_C) \cdot l(T_C) = \ln(\dfrac{U_S + Z_C(T_C)I_S}{U_R - Z_C(T_C)I_R})$, $\quad Z_C(T_C)$ is a positive sequence im-

pedance, $\gamma(T_C)$ is the propagation constant of the power transmission line, $l(T_C)$ is the length of the power transmission line at a temperature of $T_C$, $U_R$ and $I_R$ are respectively voltage phasor and current phasor of the receiving end of the power transmission line, and $U_S$ and $I_S$ are respectively voltage phasor and current phasor of the sending end of the power transmission line;
(3) both the resistance $R(T_C)$ and the inductance $L(T_C)$ of the power transmission line are obtained on the basis of the total impedance $Z(T_C)$ of the power transmission line:

$$R(T_C) = \mathrm{Re}[Z(T_C)], \qquad L(T_C) = \frac{\mathrm{Im}[Z(T_C)]}{\omega_0}$$

in which, $\omega_0$ is the angular frequency of an AC signal;
(4) Both the inductance per unit length $L_u$ and the elongation coefficient $\varepsilon(T_C)$ of the power transmission line are obtained on the basis of the length $l(T_C)$ and the inductance of the power transmission line at a temperature of $T_C$ :

$$L_u = \frac{L(T_C)}{l(T_C)}, \qquad \varepsilon(T_C) = \frac{L(T_C)}{L_u \cdot l(T_{REF})} - 1$$

in which, $l(T_{RFF})$ is the length of the power transmission line at a reference temperature of $T_{REF}$ ;
(5) Both the resistivity $\rho(T_C)$ and the real-time temperature $T_C$ of the power transmission line are obtained on the basis of the elongation coefficient $\varepsilon(T_C)$ and the resistance per unit length of the power transmission line:

$$\rho(T_C) = \frac{R(T_C) \cdot A(T_{REF})}{[1 + \varepsilon(T_C)]^2 l(T_{REF})}$$

in which, $A(T_{REF})$ is the cross sectional area of the power transmission line at the reference temperature of $T_{REF}$, the real-time temperature $T_C$ of the power transmission line is obtained by referring to the power transmission line resistivity-temperature chart;
(6) A heat loss per unit length $q_{src}(T_C)$ of the power transmission line is estimated on the basis of the real-time temperature $T_C$ and the temperature change rate of the power transmission line:

$$q_{src}(T_C) = \frac{1}{l(T_C)} \mathrm{Re}\left(U_S I_S^* - U_R I_R^*\right) - mC_p \cdot \frac{dT_C}{dt}$$
$$= a_0 + a_1 \cdot T_C$$

in which, $m\,C_p$ is the total thermal capacity per unit length of the power transmission line, $a_0$ and $a_1$ are undetermined coefficients of a fitted curve $q_{src}(T_C) = \alpha_0 + \alpha_1 \cdot T_C$, further the maximum permissible current estimated value

$$I_{max} = \sqrt{\frac{(a_0 + a_1 \cdot T_{Max})}{R_u(T_{Max})}}$$ of the power transmission line is obtained, wherein $T_{Max}$ is the maximum permissible temperature of the power transmission line, namely the set thermal allowance temperature;

(7) A thermal allowance out-of-limit time is obtained by carrying out an iterative operation on the basis of the maximum permissible current estimated value $I_{max}$ of the power transmission line and a heat loss model, the iterative operation has such steps as below:

A) the resistance per unit length $R_a(T_C)$ of the power transmission line is estimated on the basis of an estimated value of the real-time temperature $T_C$ of the power transmission line:

$$R_u(T_C) = \frac{R(T_C)}{l(T_C)} = \frac{\rho(T_C) \cdot l(T_C)}{A(T_C) \cdot l(T_C)} = \frac{\rho(T_C)}{A(T_C)}$$

in which, $A(T_C)$ is the cross sectional area of the power transmission line at the temperature of $T_C$, both $\rho(T_C)$ and $A(T_C)$ are obtained by referring to a real-time temperature table regarding the power transmission line;

B) the temperature change rate $\frac{dT_C}{dt}$ of the power transmission line is calculated;

C) the current estimated temperature value $T_C(t + \Delta t)$ of the power transmission line is obtained on the basis of iteration time interval $\Delta t$:

$$T_C(t + \Delta t) = T_C(t) + \frac{dT_C}{dt}\Delta t \quad ,$$

wherein $t$ is the iteration time;

D) the current estimated temperature value $T_C(t + \Delta t)$ of the power transmission line is compared with the set thermal allowance temperature $T_{Max}$ : the current iteration time $t'$ is outputted as the thermal allowance out-of-limit time and the iteration is over if the current estimated temperature value $T_C(t + \Delta t)$ of the power transmission line is more than the set thermal allowance temperature $T_{Max}$, wherein the current iteration time $t'$ is equal to the iteration time $t$; Step E) is switched into if the current estimated temperature value $T_C(t + \Delta t)$ of the power transmission line is not more than the set thermal allowance temperature $T_{Max}$;

E) the current iteration time $t'$ is outputted as the iteration time $t$ added with the iteration time interval $\Delta t$ if the current estimated temperature value $T_C(t + \Delta t)$ of the power transmission line is not more than the set thermal allowance temperature $T_{Max}$ ; the iteration result "out-of-limit impossible" is outputted if the temperature variation is less than a set value (a set value of the measurement system), otherwise Step A) is switched into.

Further, the total impedance $Z(T_C)$ of the power transmission line is calculated on the basis of a telegraph equation:

$$U_S = \frac{U_R - I_R Z_C(T_C)}{2}e^{\gamma(T_C) \cdot l(T_C)} + \frac{U_R + I_R Z_C(T_C)}{2}e^{-\gamma(T_C) \cdot l(T_C)}$$

$$I_S = \frac{U_R / Z_C(T_C) - I_R}{2}e^{\gamma(T_C) \cdot l(T_C)} - \frac{U_R / Z_C(T_C) + I_R}{2}e^{-\gamma(T_C) \cdot l(T_C)}$$

Further, the resistivity-temperature relational expression based on a fixed slope in Step (5) is as below:

$$T_C = T_{REF} - \left[\frac{\rho(T_C)}{\rho(T_{REF})} - 1\right] \cdot \alpha^{-1}$$

in which, $\alpha$ is the fixed slope regarding resistivity-temperature variation, and $\rho(T_{REF})$ is a resistivity at the reference temperature of $T_{REF}$.

Further, the temperature change rate $\dfrac{dT_C}{dt}$ is obtained on the basis of the last two estimated temperature values $T_C(t_0)$ and $T_C(t_{-1})$ of the power transmission line temperature $T_C$ in Step (5): $\dfrac{dT_C}{dt} = \dfrac{T_C(t_0) - T_C(t_{-1})}{t_0 - t_{-1}}$ .

Further, the undetermined coefficients $a_0$ and $a_1$ are obtained via a least square method:

$$a_1 = \frac{\mathbf{T}_C^{\,T}\mathbf{q}_{src} - \mathbf{T}_C^{\,T}\mathbf{II}^{T}\mathbf{q}_{src}}{\mathbf{T}_C^{\,T}\mathbf{T}_C - \mathbf{T}_C^{\,T}\mathbf{II}^{T}\mathbf{T}_C}$$

$$a_0 = \frac{\mathbf{I}^{T}\mathbf{q}_{src}\mathbf{T}_C^{\,T}\mathbf{T}_C - \mathbf{T}_C^{\,T}\mathbf{q}_{src}\mathbf{I}^{T}\mathbf{T}_C}{\mathbf{T}_C^{\,T}\mathbf{T}_C - \mathbf{I}^{T}\mathbf{T}_C\mathbf{I}^{T}\mathbf{T}_C}$$

in which, $\mathbf{T}_C$ is an estimated temperature matrix of the power transmission line, $\mathbf{q}_{src}$ is a heat loss matrix and $\mathbf{I}$ is a column matrix whose elements are equal to 1.

Further, the temperature change rate $\dfrac{dT_C}{dt} = \dfrac{1}{mC_p}[I^2 \cdot R_u(T_C) - (a_0 + a_1 T_C)]$ in which ,

$$I = I_{max} = \sqrt{\frac{(a_0 + a_1 \cdot T_{Max})}{R_u(T_{Max})}} .$$

In conclusion, In the method for estimating a dynamic power transmission line capacity by using a synchronized phasor technology in the invention, through a power transmission line model based on mechanical characteristics, thermodynamic characteristics and power characteristics, the length of the power transmission line is calculated by using values of synchronized voltage and current phasors at two sides of the power transmission line, and a resistivity of the power transmission line is obtained according to a total resistance of the power transmission line, so as to obtain an estimated value of a real-time temperature of the power transmission line, thereby achieving the objective of determining the on-line power transmission capacity of the power transmission line without adding any additional device.

BRIEF DESCRIPTION OF THE DRAWINGS

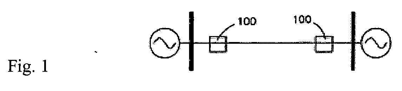

Fig. 1 is a constitutional diagram of the power transmission line and the synchronized phasor measurement units in the invention.

DETAILED DESCRIPTION OF THE EMBODIMENTS

Further detailed description of the invention is made in conjunction with the accompanying drawings and embodiments in order to have a more particular knowledge of characteristics, technological means, specific objectives and functions of the invention.

As shown in Fig. 1, a method for estimating a dynamic power transmission line capacity by using a synchronized phasor technology in the invention is realized by the steps as below:

(1) Synchronized phasor measurement units (100) are arranged at two sides of a power transmission line, one side of the power transmission line is a receiving end and the opposite side of the power transmission line is a sending end; the synchronized phasor measurement units (100) measure voltage and current phasors of the power transmission line and transmit the voltage and current phasors to a data buffer of a measurement system;

(2) The power transmission line voltage and current phasors data in the data buffer of the measurement system is used for calculation of the total impedance $Z(T_C)$ of the power transmission line on the basis of a telegraph equation:

$$U_S = \frac{U_R - I_R Z_C(T_C)}{2} e^{\gamma(T_C) \cdot l(T_C)} + \frac{U_R + I_R Z_C(T_C)}{2} e^{-\gamma(T_C) \cdot l(T_C)}$$

$$I_S = \frac{U_R / Z_C(T_C) - I_R}{2} e^{\gamma(T_C) \cdot l(T_C)} - \frac{U_R / Z_C(T_C) + I_R}{2} e^{-\gamma(T_C) \cdot l(T_C)}$$

in which, $Z_C(T_C)$ is a positive sequence impedance of the power transmission line, $\gamma(T_C)$ is the propagation constant of the power transmission line, $l(T_C)$ is the length of the power transmission line at a temperature of $T_C$, $U_R$ and $I_R$ are respectively voltage phasor and current phasor of the receiving end of the power transmission line, and $U_S$ and $I_S$ are respectively voltage phasor and current phasor of the sending end of the power transmission line;

at this moment, $Z_C(T_C) = \sqrt{\dfrac{U_S^2 - U_R^2}{I_S^2 - I_R^2}}$, $\gamma(T_C) \cdot l(T_C) = \ln(\dfrac{U_S + Z_C(T_C)I_S}{U_R - Z_C(T_C)I_R})$, the total impedance of the power transmission line $Z(T_C) = Z_C(T_C) \cdot \gamma(T_C) \cdot l(T_C)$.

(3) Both the resistance $R(T_C)$ and the inductance $L(T_C)$ of the power transmission line are obtained on the basis of the total impedance $Z(T_C)$ of the power transmission line:

$$R(T_C) = \mathrm{Re}[Z(T_C)], \quad L(T_C) = \frac{\mathrm{Im}[Z(T_C)]}{\omega_0}$$

in which, $\omega_b$ is the angular frequency of an AC signal;

(4) Both the inductance per unit length $L_u$ and the elongation coefficient $\varepsilon(T_C)$ of the power transmission line are obtained on the basis of the length $l(T_C)$ and the inductance $L(T_C)$ of the power transmission line at a temperature of $T_C$ :

$$L_u = \frac{L(T_C)}{l(T_C)}, \quad \varepsilon(T_C) = \frac{L(T_C)}{L_u \cdot l(T_{REF})} - 1$$

in which, $l(T_{REF})$ is the length of the power transmission line at a reference temperature of $T_{REF}$.

(5) Both the resistivity $\rho(T_C)$ and the real-time temperature $T_C$ of the power transmission line are obtained on the basis of the elongation coefficient $\varepsilon(T_C)$ and the resistance per unit length of the power transmission line:

$$\rho(T_C) = \frac{R(T_C) \cdot A(T_{REF})}{[1 + \varepsilon(T_C)]^2 l(T_{REF})}$$

in which, $A(T_{REF})$ is the cross sectional area of the power transmission line at the reference temperature of $T_{REF}$, the real-time temperature $T_C$ of the power transmission line is obtained by referring to the power transmission line resistivity-temperature chart provided by the manufacturer, a resistivity-temperature relational expression based on a fixed slope is as below:

$$T_C = T_{REF} - \left[ \frac{\rho(T_C)}{\rho(T_{REF})} - 1 \right] \cdot \alpha^{-1}$$

in the formula, $\alpha$ is the fixed slope regarding resistivity-temperature variation, and $\rho(T_{REF})$ is a resistivity at the reference temperature of $T_{REF}$.

(6) A heat loss per unit length $q_{src}(T_C)$ of the power transmission line is estimated on the basis of the real-time temperature $T_C$ and the temperature change rate of the power transmission line:

$$q_{src}(T_C) = \frac{1}{l(T_C)} \text{Re}\left(U_S I_S^* - U_R I_R^*\right) - mC_p \cdot \frac{dT_C}{dt}$$

$$= a_0 + a_1 \cdot T_C$$

in which, $mC_p$ is the total thermal capacity per unit length of the power transmission line, $a_0$ and $a_1$ are undetermined coefficients of a fitted curve $q_{src}(T_C) = a_0 + a_1 \cdot T_C$, the temperature change rate $\frac{dT_C}{dt}$ (namely, the temperature derivative) is obtained on the basis of the last two estimated temperature values $T_C(t_0)$ and $T_C(t_{-1})$ of the power transmission line temperature $T_C$ in Step (5): $\frac{dT_C}{dt} = \frac{T_C(t_0) - T_C(t_{-1})}{t_0 - t_{-1}}$ .

At this moment, the undetermined coefficients $a_0$ and $a_1$ of the fitted curve $q_{src}(T_C) = a_0 + a_1 \cdot T_C$ are obtained via a least square method:

$$a_1 = \frac{\mathbf{T}_C^T \mathbf{q}_{src} - \mathbf{T}_C^T \mathbf{II}^T \mathbf{q}_{src}}{\mathbf{T}_C^T \mathbf{T}_C - \mathbf{T}_C^T \mathbf{II}^T \mathbf{T}_C}$$

$$a_0 = \frac{\mathbf{I}^T \mathbf{q}_{src} \mathbf{T}_C^T \mathbf{T}_C - \mathbf{T}_C^T \mathbf{q}_{src} \mathbf{I}^T \mathbf{T}_C}{\mathbf{T}_C^T \mathbf{T}_C - \mathbf{I}^T \mathbf{T}_C \mathbf{I}^T \mathbf{T}_C}$$

in which, $\mathbf{T}_C$ is an estimated temperature matrix of the power transmission line, $\mathbf{q}_{src}$ is a heat loss matrix and $\mathbf{I}$ is a column matrix whose elements are equal to 1, further the maximum permissible current estimated value $\mathbf{I}_{max} = \sqrt{\frac{(a_0 + a_1 \cdot T_{Max})}{R_u(T_{Max})}}$ of the power transmission line is obtained, wherein $T_{Max}$ is the maximum permissible temperature of the power transmission line, namely the set thermal allowance temperature.

(7) A thermal allowance out-of-limit time is obtained by carrying out an iterative operation on the basis of the maximum permissible current estimated value $\mathbf{I}_{max}$ of the power transmission line and a heat loss model, the iterative operation has such steps as below:

A) the resistance per unit length $R_u(T_C)$ of the power transmission line is estimated on the basis of an estimated value of the real-time temperature $T_C$ of the power transmission line:

$$R_u(T_C) = \frac{R(T_C)}{l(T_C)} = \frac{\rho(T_C) \cdot l(T_C)}{A(T_C) \cdot l(T_C)} = \frac{\rho(T_C)}{A(T_C)}$$

in which, $A(T_C)$ is the cross sectional area of the power transmission line at the temperature of $T_C$, both $\rho(T_C)$ and $A(T_C)$ are obtained by referring to a real-time temperature table regarding the power transmission line via a formula or a form provided by the manufacturer regarding the power transmission line.

B) The temperature change rate $\frac{dT_C}{dt}$ of the power transmission line is calculated:

$$\frac{dT_C}{dt} = \frac{1}{mC_p}[I^2 \cdot R_u(T_C) - (a_0 + a_1 T_C)] \quad \text{in which} \quad I = I_{max} = \sqrt{\frac{(a_0 + a_1 \cdot T_{Max})}{R_u(T_{Max})}} \quad .$$

C) The current estimated temperature value $T_C(t + \Delta t)$ of the power transmission line is obtained on the basis of the iteration time interval $\Delta t$:

$$T_C(t + \Delta t) = T_C(t) + \frac{dT_C}{dt}\Delta t ,$$

wherein $t$ is the iteration time.

D) The current estimated temperature value $T_C(t + \Delta t)$ of the power transmission line is compared with the set thermal allowance temperature $T_{Max}$: the current iteration time $t'$ is outputted as the thermal allowance out-of-limit time and the iteration is over if the current estimated temperature value $T_C(t + \Delta t)$ of the power transmission line is more than the set thermal allowance temperature $T_{Max}$, wherein the current iteration time $t'$ is equal to the iteration time $t$; Step E) is switched into if the current estimated temperature value $T_C(t + \Delta t)$ of the power transmission line is not more than the set thermal allowance temperature $T_{Max}$.

E) The current iteration time $t'$ is outputted as the iteration time $t$ added with the iteration time interval $\Delta t$ if the current estimated temperature value $T_C(t + \Delta t)$ of the power transmission line is not more than the set thermal allowance temperature $T_{Max}$ ; the iteration result "out-of-limit impossible" is outputted if the temperature variation is less than a set value (a set value of the measurement system), otherwise Step A) is switched into.

In conclusion, In the method for estimating a dynamic power transmission line capacity by using a synchronized phasor technology in the invention, through a power transmission line model based on mechanical characteristics, thermodynamic characteristics and power characteristics, the length of the power transmission line is calculated by using values of synchronized voltage and current phasors at two sides of the power transmission line, and a resistivity of the power transmission line is obtained according to a total resistance of the power transmission line, so as to obtain an estimated value of a real-time temperature of the power transmission line, thereby achieving the objective of determining the on-line power transmission capacity of the power transmission line without adding any additional device.

The above-mentioned embodiment is only one embodiment of the invention, which is subject to a detailed and specific description but not interpreted as restriction of scope of the invention. It is necessary to point out that, those of ordinary skill in the art can, under the precondition of not breaking away from the inventive concept, make a plurality of changes and improvements of the embodiment mentioned above, which is within the scope of protection of the invention. Therefore, the scope of protection of the invention is subject to claims enclosed.

**Claims**

1. A method for estimating dynamic power transmission line capacity by using synchronized phasor technology **characterized in that** it comprises the steps as below:

   (1) Synchronized phasor measurement units (100) are arranged at two sides of a power transmission line, one side of the power transmission line is a receiving end and the opposite side of the power transmission line is a sending end; the synchronized phasor measurement units (100) measure voltage and current phasors of the power transmission line and transmit the voltage and current phasors to a data buffer of a measurement system;
   (2) The power transmission line voltage and current phasors data in the data buffer of the measurement system is used for calculation of the total impedance of the power transmission line $Z(T_C) = Z_C(T_C) \cdot \gamma(T_C) \cdot l(T_C)$, in which,

   $$Z_C(T_C) = \sqrt{\frac{U_S^2 - U_R^2}{I_S^2 - I_R^2}} , \qquad \gamma(T_C) \cdot l(T_C) = \ln(\frac{U_S + Z_C(T_C)I_S}{U_R - Z_C(T_C)I_R}) , \qquad Z_C(T_C) \text{ is a positive sequence imped-}$$

   ance of the power transmission line, $\gamma(T_C)$ is the propagation constant of the power transmission line, $l(T_C)$ is the length of the power transmission line at a temperature of $T_C$, $U_R$ and $I_R$ are respectively voltage phasor and current phasor of the receiving end of the power transmission line, and $U_S$ and $I_S$ are respectively voltage phasor and current phasor of the sending end of the power transmission line;
   (3) both the resistance $R(T_C)$ and the inductance $L(T_C)$ of the power transmission line are obtained on the basis of the total impedance $Z(T_C)$ of the power transmission line:

   $$R(T_C) = \mathrm{Re}[Z(T_C)] , \qquad L(T_C) = \frac{\mathrm{Im}[Z(T_C)]}{\omega_0}$$

in which, $\omega_b$ is the angular frequency of the measured voltage or current;

(4) Both the inductance per unit length $L_u$ and the elongation coefficient $\varepsilon(T_C)$ of the power transmission line are obtained on the basis of the length $l(T_C)$ and the inductance $L(T_C)$ of the power transmission line at a temperature of $T_C$ :

$$L_u = \frac{L(T_C)}{l(T_C)} , \quad \varepsilon(T_C) = \frac{L(T_C)}{L_u \cdot l(T_{REF})} - 1$$

in which, $l(T_{REF})$ is the length of the power transmission line at a reference temperature of $T_{REF}$ ;

(5) Both the resistivity $\rho(T_C)$ and the real-time temperature $T_C$ of the power transmission line are obtained on the basis of the elongation coefficient $\varepsilon(T_C)$ and the resistance per unit length of the power transmission line:

$$\rho(T_C) = \frac{R(T_C) \cdot A(T_{REF})}{[1 + \varepsilon(T_C)]^2 l(T_{REF})}$$

in which, $A(T_{REF})$ is the cross sectional area of the power transmission line at the reference temperature of $T_{REF}$, the real-time temperature $T_C$ of the power transmission line is obtained by referring to the power transmission line resistivity-temperature chart;

(6) A heat loss per unit length $q_{src}(T_C)$ of the power transmission line is estimated on the basis of the real-time temperature $T_C$ and the temperature change rate of the power transmission line:

$$q_{src}(T_C) = \frac{1}{l(T_C)} \mathrm{Re}\left(U_S I_S^* - U_R I_R^*\right) - mC_p \cdot \frac{dT_C}{dt}$$
$$= a_0 + a_1 \cdot T_C$$

in which, $mC_p$ is the total thermal capacity per unit length of the power transmission line, $a_0$ and $a_1$ are coefficients of a fitted curve $q_{src}(T_C) = a_0 + a_1 \cdot T_C$, further the maximum permissible current estimated value $I_{max} = \sqrt{\frac{(a_0 + a_1 \cdot T_{Max})}{R_u(T_{Max})}}$ of the power transmission line is obtained, wherein $T_{Max}$ is the maximum permissible temperature of the power transmission line, namely the set thermal allowance temperature;

(7) A thermal allowance out-of-limit time is obtained by carrying out an iterative operation on the basis of the maximum permissible current estimated value $I_{max}$ of the power transmission line and a heat loss model, the iterative operation has such steps as below:

A) the resistance per unit length $R_u(T_C)$ of the power transmission line is estimated on the basis of an estimated value of the real-time temperature $T_C$ of the power transmission line:

$$R_u(T_C) = \frac{R(T_C)}{l(T_C)} = \frac{\rho(T_C) \cdot l(T_C)}{A(T_C) \cdot l(T_C)} = \frac{\rho(T_C)}{A(T_C)}$$

in which, $A(T_C)$ is the cross sectional area of the power transmission line at the temperature of $T_C$, both $\rho(T_C)$ and $A(T_C)$ are obtained by referring to a real-time temperature table regarding the power transmission line;

B) the temperature change rate $\frac{dT_C}{dt}$ of the power transmission line is calculated;

C) the current estimated temperature value $T_C(t + \Delta t)$ of the power transmission line is obtained on the basis of an iteration time interval $\Delta t$ :

$$T_C(t + \Delta t) = T_C(t) + \frac{dT_C}{dt}\Delta t \;,$$

wherein $t$ is the iteration time;

D) the current estimated temperature value $T_C(t + \Delta t)$ of the power transmission line is compared with the set thermal allowance temperature $T_{Max}$: the current iteration time $t'$ is outputted as the thermal allowance out-of-limit time and the iteration is over if the current estimated temperature value $T_C(t + \Delta t)$ of the power transmission line is more than the set thermal allowance temperature $T_{Max}$, wherein the current iteration time $t'$ is equal to the iteration time $t$; Step E) is switched into if the current estimated temperature value $T_C(t + \Delta t)$ of the power transmission line is not more than the set thermal allowance temperature $T_{Max}$;

E) the current iteration time $t'$ is outputted as the iteration time $t$ added with the iteration time interval $\Delta t$ if the current estimated temperature value $T_C(t + \Delta t)$ of the power transmission line is not more than the set thermal allowance temperature $T_{Max}$; the iteration result "out-of-limit impossible" is outputted if the temperature variation dTc/dt is less than a set value (a set value of the measurement system); otherwise Step A) is switched into.

2. The method for estimating dynamic power transmission line capacity by using synchronized phasor technology according to claim 1, **characterized in that** the total impedance $Z(T_C)$ of the power transmission line is calculated on the basis of a telegraph equation:

$$U_S = \frac{U_R - I_R Z_C(T_C)}{2}e^{\gamma(T_C)\cdot l(T_C)} + \frac{U_R + I_R Z_C(T_C)}{2}e^{-\gamma(T_C)\cdot l(T_C)}$$

$$I_S = \frac{U_R / Z_C(T_C) - I_R}{2}e^{\gamma(T_C)\cdot l(T_C)} - \frac{U_R / Z_C(T_C) + I_R}{2}e^{-\gamma(T_C)\cdot l(T_C)}$$

3. The method for estimating dynamic power transmission line capacity by using synchronized phasor technology according to any preceding claim, **characterized in that** the resistivity-temperature relational expression based on a fixed slope in Step (5) is as below:

$$T_C = T_{REF} - \left[\frac{\rho(T_C)}{\rho(T_{REF})} - 1\right]\cdot \alpha^{-1}$$

in the formula, $\alpha$ is the fixed slope regarding resistivity-temperature variation, and $\rho(T_{REF})$ is a resistivity at the reference temperature of $T_{REF}$.

4. The method for estimating dynamic power transmission line capacity by using synchronized phasor technology according to any preceding claim, **characterized in that** the temperature change rate $\frac{dT_C}{dt}$ is obtained on the basis of the last two estimated temperature values $T_C(t_0)$ and $T_C(t_{-1})$ of the power transmission line temperature $T_C$ in Step (5): $\frac{dT_C}{dt} = \frac{T_C(t_0) - T_C(t_{-1})}{t_0 - t_{-1}}$.

5. The method for estimating dynamic power transmission line capacity by using synchronized phasor technology according to any preceding claim, **characterized in that** the undetermined coefficients $a_0$ and $a_1$ are obtained via a least square method:

$$a_1 = \frac{\mathbf{T}_C^T \mathbf{q}_{src} - \mathbf{T}_C^T \mathbf{II}^T \mathbf{q}_{src}}{\mathbf{T}_C^T \mathbf{T}_C - \mathbf{T}_C^T \mathbf{II}^T \mathbf{T}_C}$$

$$a_0 = \frac{\mathbf{I}^T \mathbf{q}_{src} \mathbf{T}_C{}^T \mathbf{T}_C - \mathbf{T}_C{}^T \mathbf{q}_{src} \mathbf{I}^T \mathbf{T}_C}{\mathbf{T}_C{}^T \mathbf{T}_C - \mathbf{I}^T \mathbf{T}_C \mathbf{I}^T \mathbf{T}_C}$$

in which, $\mathbf{T}_C$ is an estimated temperature matrix of the power transmission line, $\mathbf{q}_{src}$ is a heat loss matrix and $\mathbf{I}$ is a column matrix whose elements are equal to 1.

**6.** The method for estimating dynamic power transmission line capacity by using synchronized phasor technology according to any preceding claim, **characterized in that** the temperature change rate is calculated according to

$$\frac{dT_C}{dt} = \frac{1}{mC_p}[I^2 \cdot R_u(T_C) - (a_0 + a_1 T_C)]$$ , in which $I = I_{max} = \sqrt{\dfrac{(a_0 + a_1 \cdot T_{Max})}{R_u(T_{Max})}}$ .

**Patentansprüche**

**1.** Verfahren zum Schätzen der dynamischen Kapazität einer Stromübertragungsleitung unter Verwendung einer synchronisierten Phasor-Technologie, **dadurch gekennzeichnet, dass** es folgende Schritte umfasst:

1) synchronisierte Phasor-Messeinheiten (100) werden auf zwei Seiten einer Stromübertragungsleitung angeordnet, wobei eine Seite der Stromübertragungsleitung eine Empfängerseite ist und die gegenüberliegende Seite der Stromübertragungsleitung eine Senderseite ist; die synchronisierten Phasor-Messeinheiten (100) messen die Spannungs- und Strom-Phasoren der Stromübertragungsleitung und übertragen die Spannungs- und Strom-Phasoren an einen Datenpuffer eines Messsystems;

2) die Daten der Spannungs- und Strom-Phasoren der Stromübertragungsleitung in dem Datenpuffer des Messsystems werden zur Berechnung der Gesamtimpedanz der Stromübertragungsleitung $Z(T_C) = Z_C(T_C) \cdot \gamma(T_C)$

$\cdot l(T_C)$ verwendet, wobei $Z_C(T_C) = \sqrt{\dfrac{U_S^2 - U_R^2}{I_S^2 - I_R^2}}$ , $\gamma(T_C) \cdot l(T_C) = \ln(\dfrac{U_S + Z_C(T_C)I_S}{U_R - Z_C(T_C)I_R})$ , $Z_C(T_C)$

eine Mitimpedanz der Stromübertragungsleitung ist, $\gamma(T_C)$ die Übertragungskonstante der Stromübertragungsleitung ist, $l(T_C)$ die Länge der Stromübertragungsleitung bei einer Temperatur $T_C$ ist, $U_R$ und $I_R$ jeweils der Spannungs-Phasor und der Strom-Phasor der Empfängerseite der Stromübertragungsleitung sind, und $U_S$ und $I_S$ jeweils der Spannungs-Phasor und der Strom-Phasor der Senderseite der Stromübertragungsleitung sind;

3) sowohl der Widerstand $R(T_C)$ als auch die Induktivität $L(T_C)$ der Stromübertragungsleitung auf der Grundlage der Gesamtimpedanz $Z(T_C)$ der Stromübertragungsleitung erzielt werden: $R(T_C) = \mathrm{Re}[Z(T_C)]$,

$L(T_C) = \dfrac{Im[Z(T_C)]}{\omega_0}$ , wobei $\omega_0$ die Winkelfrequenz der gemessenen Spannung oder des gemessenen Stroms ist;

4) sowohl die Induktivität pro Längeneinheit $L_\Omega$ als auch der Ausdehnungskoeffizient $\varepsilon(T_C)$ der Stromübertragungsleitung auf der Grundlage der Länge $l(T_C)$ und der Induktivität $L(T_C)$ der Stromübertragungsleitung bei einer Temperatur $T_C$ erzielt werden: $L_u = \dfrac{L(T_C)}{l(T_C)}$ , $\varepsilon(T_C) = \dfrac{L(T_C)}{L_u \cdot l(T_{REF})} - 1$ , wobei $l(T_{REF})$ die Länge der Stromübertragungsleitung bei einer Referenztemperatur $T_{REF}$ ist;

5) sowohl der spezifische Widerstand $\rho(T_C)$ als auch die Echtzeittemperatur $T_C$ der Stromübertragungsleitung auf der Grundlage des Ausdehnungskoeffizienten $\varepsilon(T_C)$ und des Widerstands pro Längeneinheit der Stromü-

bertragungsleitung erzielt werden: $\rho(T_C) = \dfrac{R(T_C) \cdot A(T_{REF})}{[1 + \varepsilon(T_C)]^2 l(T_{REF})}$ , wobei $A(T_{REF})$ die Querschnittsfläche der Stromübertragungsleitung bei der Referenztemperatur $T_{PEF}$ ist, wobei die Echtzeittemperatur $T_C$ der Stromübertragungsleitung mit Bezug auf das Diagramm des spezifischen Widerstands und der Temperatur der Stromübertragungsleitung erzielt wird;

6) ein Wärmeverlust pro Längeneinheit $q_{src}(T_C)$ der Stromübertragungsleitung auf der Grundlage der Echtzeittemperatur $T_C$ und der Temperaturänderungsrate der Stromübertragungsleitung geschätzt wird:

$$q_{src}(T_C) = \frac{1}{l(T_C)} \text{Re}\left(U_S I_S^* - U_R I_R^*\right) - mC_p \cdot \frac{dT_C}{dt}$$

$$= a_0 + a_1 \cdot T_C \qquad ,$$

wobei $mC_p$ die gesamte Wärmekapazität pro Längeneinheit der Stromübertragungsleitung ist, $a_0$ und $a_1$ Koeffizienten einer Ausgleichskurve $q_{src}(T_C) = a_0 + a_1 \cdot T_C$ sind, ferner der maximal zulässige geschätzte Wert

$$I_{max} = \sqrt{\frac{(a_0 + a_1 \cdot T_{Max})}{R_u(T_{Max})}}$$ der Stromübertragungsleitung erzielt wird, wobei $T_{Max}$ die maximal zulässige Temperatur der Stromübertragungsleitung, nämlich die thermisch erlaubte Sollwerttemperatur, ist;

7) eine thermisch erlaubte Grenzwertüberschreitungszeit wird durch Ausführen einer iterativen Operation auf der Grundlage des maximal zulässigen aktuellen geschätzten Wertes $I_{max}$ der Stromübertragungsleitung und eines Wärmeverlustmodells erzielt, wobei die iterative Operation die folgenden Schritte aufweist:

A) der Widerstand pro Längeneinheit $R_u(T_C)$ der Stromübertragungsleitung wird auf der Grundlage eines geschätzten Wertes der Echtzeittemperatur $T_C$ der Stromübertragungsleitung geschätzt:

$$R_u(T_C) = \frac{R(T_C)}{l(T_C)} = \frac{\rho(T_C) \cdot l(T_C)}{A(T_C) \cdot l(T_C)} = \frac{\rho(T_C)}{A(T_C)} \qquad ,$$

wobei $A(T_C)$ die Querschnittsfläche der Stromübertragungsleitung bei einer Temperatur $T_C$ ist, wobei sowohl $\rho(T_C)$ als auch $A(T_C)$ mit Bezug auf eine Echtzeit-Temperaturtabelle bezüglich der Stromübertragungsleitung erzielt werden;

B) die Temperaturänderungsrate $\frac{dT_C}{dt}$ der Stromübertragungsleitung wird berechnet;

C) der aktuelle geschätzte Temperaturwert $T_C(t+\Delta t)$ der Stromübertragungsleitung wird auf der Grundlage eines Iterationszeitintervalls $\Delta t$ erzielt: $T_C(t+\Delta t) = T_C(t) + \frac{dT_C}{dt}\Delta t$, wobei t die Iterationszeit ist;

D) der aktuelle geschätzte Temperaturwert $T_C(t+\Delta t)$ der Stromübertragungsleitung wird mit der thermisch erlaubten Sollwerttemperatur $T_{Max}$ verglichen; die aktuelle Iterationszeit t' wird als thermisch erlaubte Grenzwertüberschreitungszeit ausgegeben, und die Iteration ist beendet, falls der aktuelle geschätzte Temperaturwert $T_C(t+\Delta t)$ der Stromübertragungsleitung größer als die thermisch erlaubte Sollwerttemperatur $T_{Max}$ ist, wobei die aktuelle Iterationszeit t' gleich der Iterationszeit t ist; es wird auf Schritt E) umgeschaltet, falls der aktuelle geschätzte Temperaturwert $T_C(t+\Delta t)$ der Stromübertragungsleitung nicht größer als die thermisch erlaubte Sollwerttemperatur $T_{Max}$ ist;

E) die aktuelle Iterationszeit t' wird als Iterationszeit t zuzüglich des Iterationszeitintervalls $\Delta t$ ausgegeben, falls der aktuell geschätzte Temperaturwert $T_C(t+\Delta t)$ der Stromübertragungsleitung nicht größer als die thermisch erlaubte Sollwerttemperatur $T_{Max}$ ist; das Iterationsergebnis "Grenzwertüberschreitung unmöglich" wird ausgegeben, falls die Temperaturvariation $dT_C/dt$ kleiner als ein Sollwert ist (ein Sollwert des Messsystems); ansonsten wird auf Schritt A) umgeschaltet.

2. Verfahren zum Schätzen der dynamischen Kapazität einer Stromübertragungsleitung unter Verwendung einer synchronisierten Phasor-Technologie nach Anspruch 1, **dadurch gekennzeichnet, dass** die Gesamtimpedanz $Z(T_C)$ der Stromübertragungsleitung auf der Grundlage einer Telegraphengleichung berechnet wird:

$$U_S = \frac{U_R - I_R Z_C(T_C)}{2} e^{\gamma(T_C) \cdot l(T_C)} + \frac{U_R + I_R Z_C(T_C)}{2} e^{-\gamma(T_C) \cdot l(T_C)}$$

$$I_S = \frac{U_R / Z_C(T_C) - I_R}{2} e^{\gamma(T_C) \cdot l(T_C)} - \frac{U_R / Z_C(T_C) + I_R}{2} e^{-\gamma(T_C) \cdot l(T_C)}$$

3. Verfahren zum Schätzen der dynamischen Kapazität einer Stromübertragungsleitung unter Verwendung einer synchronisierten Phasor-Technologie nach einem der vorhergehenden Ansprüche, **dadurch gekennzeichnet, dass** der Vergleichsausdruck des spezifischen Widerstands und der Temperatur basierend auf einer festen Steilheit in Schritt (5) folgendermaßen:

$$T_C = T_{REF} - \left[ \frac{\rho(T_C)}{\rho(T_{REF})} - 1 \right] \cdot \alpha^{-1}$$

in der Formel aussieht, $\alpha$ die feste Steilheit bezüglich der Variation des spezifischen Widerstands und der Temperatur ist, und p($T_{REF}$) ein spezifischer Widerstand bei der Referenztemperatur $T_{PEF}$ ist.

4. Verfahren zum Schätzen der dynamischen Kapazität einer Stromübertragungsleitung unter Verwendung einer synchronisierten Phasor-Technologie nach einem der vorhergehenden Ansprüche, **dadurch gekennzeichnet, dass** die Temperaturänderungsrate $\frac{dT_C}{dt}$ auf der Grundlage der mindestens zwei geschätzten Temperaturwerte $T_C(t_0)$ und $T_C(t_{-1})$ der Temperatur $T_C$ der Stromübertragungsleitung in Schritt (5) erzielt wird: $\frac{dT_C}{dt} = \frac{T_C(t_0) - T_C(t_{-1})}{t_0 - t_{-1}}$ .

5. Verfahren zum Schätzen der dynamischen Kapazität einer Stromübertragungsleitung unter Verwendung einer synchronisierten Phasor-Technologie nach einem der vorhergehenden Ansprüche, **dadurch gekennzeichnet, dass** die unbestimmten Koeffizienten $a_0$ und $a_1$ über eine Methode der kleinsten Quadrate erzielt werden:

$$a_1 = \frac{\mathbf{T}_C{}^T \mathbf{q}_{src} - \mathbf{T}_C{}^T \mathbf{II}^T \mathbf{q}_{src}}{\mathbf{T}_C{}^T \mathbf{T}_C - \mathbf{T}_C{}^T \mathbf{II}^T \mathbf{T}_C}$$

$$a_0 = \frac{\mathbf{I}^T \mathbf{q}_{src} \mathbf{T}_C{}^T \mathbf{T}_C - \mathbf{T}_C{}^T \mathbf{q}_{src} \mathbf{I}^T \mathbf{T}_C}{\mathbf{T}_C{}^T \mathbf{T}_C - \mathbf{I}^T \mathbf{T}_C \mathbf{I}^T \mathbf{T}_C}$$

wobei $T_C$ eine geschätzte Temperaturmatrix der Stromübertragungsleitung ist, $q_{src}$ eine Wärmeverlustmatrix ist, und I eine Spaltenmatrix ist, deren Elemente gleich 1 sind.

6. Verfahren zum Schätzen der dynamischen Kapazität einer Stromübertragungsleitung unter Verwendung einer synchronisierten Phasor-Technologie nach einem der vorhergehenden Ansprüche, **dadurch gekennzeichnet, dass** die Temperaturänderungsrate gemäß $\frac{dT_C}{dt} = \frac{1}{mC_p}[I^2 \cdot R_u(T_C) - (a_0 + a_1 T_C)]$

berechnet wird, wobei $I = I_{max} = \sqrt{\frac{(a_0 + a_1 \cdot T_{Max})}{R_u(T_{Max})}}$ .

**Revendications**

1. Procédé pour estimer une capacité dynamique de ligne de transport d'électricité par utilisation d'une technologie de phaseurs synchronisés **caractérisé par le fait qu'**il comprend les étapes ci-dessous :

(1) des unités de mesure de phaseurs synchronisés (100) sont agencées à deux côtés d'une ligne de transport d'électricité, un côté de la ligne de transport d'électricité étant une extrémité de réception et le côté opposé de la ligne de transport d'électricité étant une extrémité d'envoi ; les unités de mesure de phaseurs synchronisés (100) mesurent des phaseurs de tension et de courant de la ligne de transport d'électricité et transmettent les phaseurs de tension et de courant à un registre tampon de données d'un système de mesure ;

(2) les données de phaseurs de tension et de courant de ligne de transport d'électricité dans le registre tampon de données du système de mesure sont utilisées pour un calcul de l'impédance totale de la ligne de transport d'électricité $Z(T_C) = Z_C(T_C) \bullet \gamma(T_C) \bullet l(T_C)$,

dans laquelle,

$$Z_C(T_C) = \sqrt{\frac{U_S^2 - U_R^2}{I_S^2 - I_R^2}} \quad , \quad \gamma(T_C) \cdot l(T_C) = \ln(\frac{U_S + Z_C(T_C)I_S}{U_R - Z_C(T_C)I_R}) \quad , \quad Z_C(T_C) \quad ,$$

est une impédance de séquence positive de la ligne de transport d'électricité, $\gamma(T_C)$ est la constante de propagation de la ligne de transport d'électricité, $l(T_C)$ est la longueur de la ligne de transport d'électricité à une température de $T_C$, $U_R$ et $I_R$ sont respectivement le phaseur de tension et le phaseur de courant de l'extrémité de réception de la ligne de transport d'électricité, et $U_S$ et $I_S$ sont respectivement le phaseur de tension et le phaseur de courant de l'extrémité d'envoi de la ligne de transport d'électricité ;

(3) à la fois la résistance $R(T_C)$ et l'inductance $L(T_C)$ de la ligne de transport d'électricité sont obtenues sur la base de l'impédance totale $Z(T_C)$ de la ligne de transport d'électricité :

$$R(T_C) = \text{Re}[Z(T_C)] \quad , \quad L(T_C) = \frac{\text{Im}[Z(T_C)]}{\omega_0}$$

dans laquelle, $\omega_0$ est la fréquence angulaire de la tension ou du courant mesuré(e) ;

(4) à la fois l'inductance par unité de longueur $L_u$ et le coefficient d'élongation $\varepsilon(T_C)$ de la ligne de transport d'électricité sont obtenus sur la base de la longueur $l(T_C)$ et de l'inductance $L(T_C)$ de la ligne de transport d'électricité à une température de $T_C$ :

$$L_u = \frac{L(T_C)}{l(T_C)} \quad , \quad \varepsilon(T_C) = \frac{L(T_C)}{L_u \cdot l(T_{REF})} - 1$$

dans laquelle, $l(T_{REF})$ est la longueur de la ligne de transport d'électricité à une température de référence de $T_{REF}$ ;

(5) à la fois la résistivité $\rho(T_C)$ et la température en temps réel $T_C$ de la ligne de transport d'électricité sont obtenues sur la base du coefficient d'élongation $\varepsilon(T_C)$ et de la résistance par unité de longueur de la ligne de transport d'électricité :

$$\rho(T_C) = \frac{R(T_C) \cdot A(T_{REF})}{[1 + \varepsilon(T_C)]^2 l(T_{REF})}$$

dans laquelle, $A(T_{REF})$ est l'aire en coupe transversale de la ligne de transport d'électricité à la température de référence de $T_{REF}$, la température en temps réel $T_C$ de la ligne de transport d'électricité est obtenue en se référant à un diagramme résistivité-température de la ligne de transport d'électricité ;

(6) une perte de chaleur par unité de longueur $q_{src}(T_C)$ de la ligne de transport d'électricité est estimée sur la base de la température en temps réel $T_C$ et du taux de changement de température de la ligne de transport d'électricité :

$$q_{src}(T_C) = \frac{1}{l(T_C)} \mathrm{Re}\left(U_S I_S^{\bullet} - U_R I_R^{\bullet}\right) - mC_p \cdot \frac{dT_C}{dt}$$
$$= a_0 + a_1 \cdot T_C$$

dans laquelle, $mC_p$ est la capacité thermique totale par unité de longueur de la ligne de transport d'électricité, $a_0$ et $a_1$ sont des coefficients d'une courbe ajustée $q_{src}(T_C) = a_0 + a_1 \cdot T_C$, en outre la valeur estimée de courant autorisé maximum $I_{max} = \sqrt{\dfrac{(a_0 + a_1 \cdot T_{Max})}{R_u(T_{Max})}}$ de la ligne de transport d'électricité est obtenue, dans laquelle $T_{Max}$

est la température autorisée maximum de la ligne de transport d'électricité, à savoir la température de tolérance thermique fixée ;

(7) un temps hors limite de tolérance thermique est obtenu par réalisation d'une opération itérative sur la base de la valeur estimée de courant autorisé maximum $I_{max}$ de la ligne de transport d'électricité et d'un modèle de perte de chaleur, l'opération itérative ayant les étapes telles qu'indiquées ci-dessous :

A) la résistance par unité de longueur $R_u(T_C)$ de la ligne de transport d'électricité est estimée sur la base d'une valeur estimée de la température en temps réel $T_C$ de la ligne de transport d'électricité :

$$R_u(T_C) = \frac{R(T_C)}{l(T_C)} = \frac{\rho(T_C) \cdot l(T_C)}{A(T_C) \cdot l(T_C)} = \frac{\rho(T_C)}{A(T_C)}$$

dans laquelle, $A(T_C)$ est l'aire en coupe transversale de la ligne de transport d'électricité à la température de $T_C$, à la fois $\rho(T_C)$ et $A(T_C)$ sont obtenues en se référant à une table de température en temps réel concernant la ligne de transport d'électricité ;

B) le taux de changement de température $\dfrac{dT_C}{dt}$ de la ligne de transport d'électricité est calculé ;

C) la valeur de température estimée courante $T_C(t + \Delta t)$ de la ligne de transport d'électricité est obtenue sur la base d'un intervalle de temps d'itération $\Delta t$ :

$$T_C(t + \Delta t) = T_C(t) + \frac{dT_C}{dt}\Delta t$$
,

dans laquelle $t$ est le temps d'itération ;

D) la valeur de température estimée courante $T_C(t + \Delta t)$ de la ligne de transport d'électricité est comparée à la température de tolérance thermique fixée $T_{Max}$ : le temps d'itération courant $t'$ est émis en tant que temps hors limite de tolérance thermique et l'itération est terminée si la valeur de température estimée courante $T_C(t + \Delta t)$ de la ligne de transport d'électricité est supérieure à la température de tolérance thermique fixée $T_{max}$, le temps d'itération courant $t'$ étant égal au temps d'itération $t$ ; il est passé à l'Etape E) si la valeur de température estimée courante $T_C(t + \Delta t)$ de la ligne de transport d'électricité n'est pas supérieure à la température de tolérance thermique fixée $T_{Max}$ ;

E) le temps d'itération courant $t'$ est émis en tant que temps d'itération t auquel on ajoute l'intervalle de temps d'itération $\Delta t$ si la valeur de température estimée courante $T_C(t + \Delta t)$ de la ligne de transport d'électricité n'est pas supérieure à la température de tolérance thermique fixée $T_{max}$ ; le résultat d'itération « hors limite impossible » est émis si la variation de température dTc/dt est inférieure à une valeur fixée (une valeur fixée du système de mesure) ; autrement il est passé à l'Etape A).

2. Procédé pour estimer une capacité dynamique de ligne de transport d'électricité par utilisation d'une technologie de phaseurs synchronisés selon la revendication 1, **caractérisé par le fait que** l'impédance totale $Z(T_C)$ de la ligne de transport d'électricité est calculée sur la base d'une équation des télégraphistes :

$$U_S = \frac{U_R - I_R Z_C(T_C)}{2} e^{\gamma(T_C) \cdot l(T_C)} + \frac{U_R + I_R Z_C(T_C)}{2} e^{-\gamma(T_C) \cdot l(T_C)}$$

$$I_S = \frac{U_R / Z_C(T_C) - I_R}{2} e^{\gamma(T_C) \cdot l(T_C)} - \frac{U_R / Z_C(T_C) + I_R}{2} e^{-\gamma(T_C) \cdot l(T_C)}$$

3. Procédé pour estimer une capacité dynamique de ligne de transport d'électricité par utilisation d'une technologie de phaseurs synchronisés selon l'une quelconque des revendications précédentes, **caractérisé par le fait que** l'expression relationnelle résistivité-température basée sur une pente fixe dans l'Etape (5) est telle que ci-dessous :

$$T_C = T_{REF} - \left[ \frac{\rho(T_C)}{\rho(T_{REF})} - 1 \right] \cdot \alpha^{-1}$$

dans la formule, $\alpha$ est la pente fixe concernant la variation résistivité-température, et $\rho(T_{REF})$ est une résistivité à la température de référence de $T_{REF}$.

4. Procédé pour estimer une capacité dynamique de ligne de transport d'électricité par utilisation d'une technologie de phaseurs synchronisés selon l'une quelconque des revendications précédentes, **caractérisé par le fait que** le taux de changement de température $\frac{dT_C}{dt}$ est obtenu sur la base des deux dernières valeurs de température estimées $T_C(t_0)$ et $T_C(t_{-1})$ de la température de ligne de transport d'électricité $T_C$ à l'Etape (5) :

$$\frac{dT_C}{dt} = \frac{T_C(t_0) - T_C(t_{-1})}{t_0 - t_{-1}} \, .$$

5. Procédé pour estimer une capacité dynamique de ligne de transport d'électricité par utilisation d'une technologie de phaseurs synchronisés selon l'une quelconque des revendications précédentes, **caractérisé par le fait que** les coefficients non déterminés $a_0$ et $a_1$ sont obtenus par l'intermédiaire d'une méthode des moindres carrés :

$$a_1 = \frac{\mathbf{T}_C^T \mathbf{q}_{src} - \mathbf{T}_C^T \mathbf{II}^T \mathbf{q}_{src}}{\mathbf{T}_C^T \mathbf{T}_C - \mathbf{T}_C^T \mathbf{II}^T \mathbf{T}_C}$$

$$a_0 = \frac{\mathbf{I}^T \mathbf{q}_{src} \mathbf{T}_C^T \mathbf{T}_C - \mathbf{T}_C^T \mathbf{q}_{src} \mathbf{I}^T \mathbf{T}_C}{\mathbf{T}_C^T \mathbf{T}_C - \mathbf{I}^T \mathbf{T}_C \mathbf{I}^T \mathbf{T}_C}$$

dans laquelle, $\mathbf{T}_C$ est une matrice de température estimée de la ligne de transport d'électricité, $\mathbf{q}_{src}$ est une matrice de perte de chaleur et $\mathbf{I}$ est une matrice colonne dont les éléments sont égaux à 1.

6. Procédé pour estimer une capacité dynamique de ligne de transport d'électricité par utilisation d'une technologie de phaseurs synchronisés selon l'une quelconque des revendications précédentes, **caractérisé par le fait que** le taux de changement de température est calculé selon $\frac{dT_C}{dt} = \frac{1}{mC_p}[I^2 \cdot R_u(T_C) - (a_0 + a_1 T_C)]$ dans laquelle ,

$$I = I_{max} = \sqrt{\frac{(a_0 + a_1 \cdot T_{Max})}{R_u(T_{Max})}} \, .$$

Fig. 1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2008017581 A1